# EUROPEAN PATENT APPLICATION

(11) **EP 4 626 187 A1**
(43) Date of publication of application: **01.10.2025**
(21) Application number: 25165182.4
(22) Date of filing: 20.03.2025
(51) Int. Cl.: H10H 20/01, H10H 29/01, H10H 29/24, H10H 29/30, H10H 29/03, H01L 25/075

(54) **MASK, TRANSFER DEVICE AND TRANSFER METHOD USING THE SAME**

(30) Priority: 29.03.2024 KR 20240043255
(71) Applicant: Samsung Display Co., Ltd., Yongin-si, Gyeonggi-do 17113 (KR)
(72) Inventor: HAN, Jeong Won, Yongin-si (KR)
(74) Representative: Marks & Clerk LLP

(57) **Abstract**

The present disclosure includes a mask, a transfer device, and a transfer method using the same. The mask includes a base layer configured to be disposed on a target substrate and defining a plurality of openings therein arranged in a first direction and a second direction crossing the first direction and an adhesive layer disposed on the base layer and configured to face a transfer substrate, where the plurality of openings defines a transfer area of the target substrate.

## Description

### BACKGROUND

### 1. Field

The present disclosure relates to a mask, a transfer device, and a transfer method using the same.

### 2. Description of the Related Art

The importance of display devices is increasing with the development of multimedia. In response to this, various types of display devices such as organic light emitting displays ("OLED"), liquid crystal displays ("LCD"), etc. are being used.

A device that displays images on a display device includes a display panel such as a light emitting display panel or a liquid crystal display panel. Among them, the light emitting display panel may include a light emitting diode ("LED"), such as an organic light emitting diode that utilizes an organic material as a fluorescent material, or an inorganic light emitting diode that utilizes an inorganic material as a fluorescent material.

When manufacturing a display panel using an inorganic light emitting diode as a light emitting diode, transfer devices should be developed to transfer the micro LED onto the display panel substrate.

### SUMMARY

Aspects and features of embodiments of the present disclosure provide a mask that may be transferred effectively regardless of the shape of the cell area, a transfer device, and a transfer method using the same.

However, aspects of the present disclosure are not restricted to the one set forth herein. The above and other aspects of the present disclosure will become more apparent to one of ordinary skill in the art to which the present disclosure pertains by referencing the detailed description of the present disclosure given below.

According to an embodiment, a mask includes: a base layer configured to be disposed on a target substrate and defining a plurality of openings therein arranged in a first direction and a second direction crossing the first direction and an adhesive layer disposed on the base layer and configured to face a transfer substrate, where the plurality of openings defines a transfer area of the target substrate.

The transfer area may correspond to a cell area of the target substrate, each of the openings may have a shape corresponding to a shape of the cell area, and each of the openings may have an area corresponding to an area of the cell area in a plan view.

Each of the openings of the mask may have an upper width equal to or wider than a lower width.

According to an embodiment, a transfer device includes: a light source portion configured to irradiate a laser beam, an upper stage disposed on a path of the laser beam and configured to support a transfer substrate, a lower stage configured to support a target substrate facing the transfer substrate and a mask configured to be disposed on the target substrate and face the transfer substrate, where the mask includes a base layer defining a plurality of openings therein arranged in a first direction and a second direction crossing the first direction and defining a transfer area of the target substrate and an adhesive layer disposed on the base layer and configured to face the transfer substrate.

The transfer area may correspond to a cell area of the target substrate, where each of the openings may have a shape corresponding to a shape of the cell area, and each of the openings may have an area corresponding to an area of the cell area in a plan view.

A width of an upper portion of each of the openings may be equal to or wider than a width of a lower portion thereof.

Each of the openings may have a side surface with a curvature.

The lower stage may include a chuck disposed at a top surface of the lower stage and capable of adsorbing to a rear surface of the target substrate.

The mask may be disposed to be spaced apart from the transfer substrate.

The adhesive layer may be disposed to face a light emitting element disposed on the transfer substrate.

The mask may be disposed in contact with the target substrate.

The light source portion may include a light source configured to generate the laser beam; and an optical system disposed on a path of the laser beam and configured to guide the laser beam.

The light source portion may irradiate the laser beam using a laser-induced forward transfer (LIFT) method or a laser lift-off (LLO) method.

The mask may have a film shape, the base layer may include at least one of polyethylene terephthalate (PET), polyurethane (PU), polyimide (PI), polycarbonate (PC), polyethylene (PE), polypropylene (PP), polysulfone (PSF), polymethylmethacrylate (PMMA), triacetyl cellulose (TAC), or cycloolefin polymer (COP), and the adhesive layer may include at least one of an acrylic-based, urethane-based, or silicone-based adhesive materials.

A transfer method of a plurality of light emitting elements includes disposing a transfer substrate and a target substrate to face each other, and disposing a mask on the target substrate to face the transfer substrate; irradiating a light source to an interface between the transfer substrate and the plurality of light emitting elements disposed on the transfer substrate to transfer the plurality of light emitting elements onto the target substrate; and removing the mask to remove at least one light emitting element, among the plurality of light emitting elements, transferred to an area other than a transfer area defined by an opening in the mask.

The transfer area may correspond to a cell area of the target substrate, and the opening may have a shape corresponding to a shape of the cell area, and the opening may have an area corresponding to an area of the cell area in a plan view.

The mask may include an adhesive layer disposed at an upper portion of the mask, and the adhesive layer is disposed to face certain light emitting elements among the plurality of light emitting elements disposed on the transfer substrate, and in the transferring of the plurality of light emitting elements onto the target substrate, some of the plurality of light emitting elements disposed on the transfer substrate may be transferred to the cell area through the opening, and the remainder of the plurality of light emitting elements may be transferred to an adhesive layer of the mask.

The plurality of light emitting elements transferred to the target substrate may form a plurality of groups, and a shape and area of each group may follow a shape and area of the opening.

In the disposing of the transfer substrate and the target substrate to face each other and the disposing of the mask on the target substrate to face the transfer substrate, an upper stage grips a peripheral portion of the transfer substrate, and a lower stage supports one surface of the target substrate.

The lower stage adsorbs and supports the one surface of the target substrate using a chuck disposed on at a top surface of the lower stage.

According to a transfer device according to embodiments, a light emitting element may be effectively transferred regardless of the shape of the cell area.

At least some of the above and other features of the invention are set out in the claims.

However, the effects of the present disclosure are not limited to the aforementioned effects, and various other effects are included in the present specification.

### BRIEF DESCRIPTION OF THE DRAWINGS

FIG. 1 is a layout diagram illustrating a display device according to one embodiment.
FIG. 2 is an example diagram illustrating one example of the pixels of FIG. 1.
FIG. 3 is an example diagram illustrating another example of the pixels of FIG. 1.
FIG. 4 is a cross-sectional view illustrating an example of a display panel cut along line A-A' of FIG. 2.
FIG. 5 is a schematic diagram illustrating a transfer device according to one embodiment.
FIG. 6 is a cross-sectional view illustrating a schematic shape of a target substrate according to one embodiment.
FIG. 7 is a plan view of a mask according to one embodiment.
FIG. 8 is a cross-sectional view of a mask of one embodiment taken along line I-I' in FIG. 7.
FIG. 9 is a flowchart illustrating a method of transferring a light emitting element according to one embodiment.
FIGS. 10 to 15 are cross-sectional or plan views to illustrate a light emitting element transfer method.
FIG. 16 is a plan view illustrating one surface of a target substrate on which light emitting elements are transferred according to one embodiment.
FIG. 17 is a schematic diagram illustrating a transfer device according to another embodiment.
FIGS. 18 and 19 are plan views of a mask according to another embodiment.
FIGS. 20 to 22 are cross-sectional views illustrating masks according to another embodiment.
FIG. 23 is a diagram to illustrate the effect of inclined sides of an opening according to one embodiment.

### DETAILED DESCRIPTION

The terminology used herein is for the purpose of describing particular embodiments only and is not intended to be limiting. As used herein, "a", "an," "the," and "at least one" do not denote a limitation of quantity, and are intended to include both the singular and plural, unless the context clearly indicates otherwise. For example, "an element" has the same meaning as "at least one element," unless the context clearly indicates otherwise. "At least one" is not to be construed as limiting "a" or "an." "Or" means "and/or." As used herein, the term "and/or" includes any and all combinations of one or more of the associated listed items. It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

It will be understood that when an element is referred to as being "on" another element, it can be directly on the other element or intervening elements may be present therebetween. In contrast, when an element is referred to as being "directly on" another element, there are no intervening elements present.

Throughout the disclosure, the expression "at least one of a, b or c" indicates only a, only b, only c, both a and b, both a and c, both b and c, all of a, b, and c, or variations thereof.

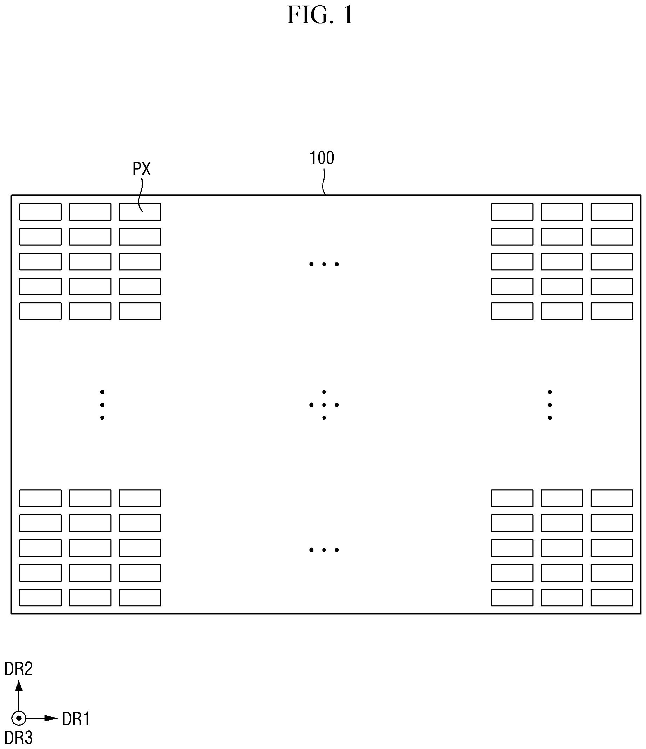

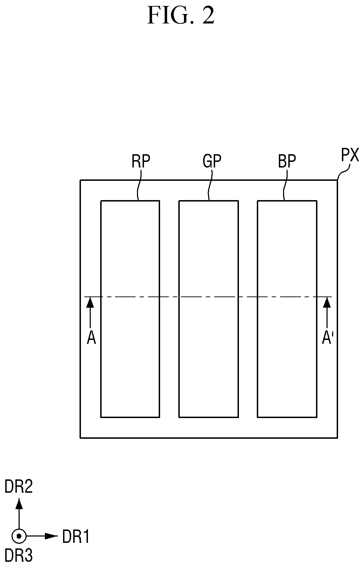

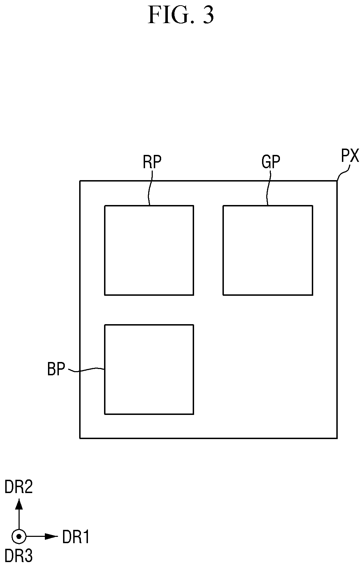

FIG. 1 is a layout diagram illustrating a display device according to one embodiment. FIG. 2 is an example diagram illustrating one example of the pixels of FIG. 1. FIG. 3 is an example diagram illustrating another example of the pixels of FIG. 1.

Referring to FIGS. 1 to 3, the display device is a device that displays displaying video or still images, such as a mobile phone, a smart phone, a tablet personal computer, a smart watch, a watch phone, a mobile communication terminal, an electronic notebook, e-books, portable multimedia players ("PMP"), navigation systems, ultra-mobile PC ("UMPC"), and the like, as well as portable electronic devices such as televisions, laptops, monitors, billboards, internet of things ("IOT"), and other products.

The display panel 100 may be formed as a rectangular shaped plane having a long side in the first direction DR1 and a short side in the second direction DR2 that intersects the first direction DR1. A corner where the long side in the first direction DR1 and the short side in the second direction DR2 meet may be rounded to have a predetermined curvature or may be formed at a right angle. The planar shape (i.e., shape in a plan view) of the display panel 100 is not limited to a rectangle, and may be formed in other polygonal, circular, or oval shapes. The display panel 100 may be formed flat but is not limited thereto. For another example, the display panel 100 may include curved portions with a constant curvature or a changing curvature disposed at edge portions of the display panel 100. In addition, the display panel 100 may be flexibly formed to be bent, curved, flexed, folded, or curled.

The display panel 100 may further include pixels PX to display an image, scan wires extending in the first direction DR1, and data lines extending in the second direction DR2. The pixels PX may be arranged in a matrix form in the first direction DR1 and the second direction DR2.

Each of the pixels PX may include a plurality of sub-pixels RP, GP, and BP, as shown in FIGS. 2 and 3. In FIGS. 2 and 3, each of the pixels PX includes three sub-pixels RP, GP, and BP, that is, a first sub-pixel RP, a second sub-pixel GP, and a third sub-pixel BP, but the embodiments of the present disclosure are not limited thereto.

The first sub-pixel RP, the second sub-pixel GP, and the third sub-pixel BP may be connected to one of the data lines and to at least one of the scan wires.

Each of the first sub-pixel RP, the second sub-pixel GP, and the third sub-pixel BP may have a planar shape of a rectangle, square, or rhombus. For example, each of the first sub-pixel RP, the second sub-pixel GP, and the third sub-pixel BP may have a rectangular planar shape with a short side in the first direction DR1 and a long side in the second direction DR2, as shown in FIG. 2. Alternatively, each of the first sub-pixel RP, the second sub-pixel GP, and the third sub-pixel BP may have a planar shape of a square or rhombus with sides having equal lengths in the first direction DR1 and the second direction DR2, as shown in FIG. 3.

As shown in FIG. 2, the first sub-pixel RP, the second sub-pixel GP, and the third sub-pixel BP may be arranged in the first direction DR1. Alternatively, one of the second sub-pixel GP and the third sub-pixel BP and the first sub-pixel RP may be arranged in the first direction DR1, and the other of the second sub-pixel GP and the first sub-pixel RP may be arranged in the second direction DR2. For example, as shown in FIG. 3, the first sub-pixel RP and the second sub-pixel GP may be arranged in the first direction DR1, and the first sub-pixel RP and the third sub-pixel BP may be arranged in the second direction DR2.

Alternatively, one of the first sub-pixel RP and the third sub-pixel BP and the second sub-pixel GP may be arranged in the first direction DR1, and the other of the first sub-pixel RP and the second sub-pixel GP may be arranged in the second direction DR2. Alternatively, one of the first sub-pixel RP and the second sub-pixel GP and the third sub-pixel BP may be arranged in the first direction DR1, and the other of the first sub-pixel RP and the third sub-pixel BP may be arranged in the second direction DR2.

The first sub-pixel RP may include a first light emitting element emitting a first light, the second sub-pixel GP may include a second light emitting element emitting a second light, and the third sub-pixel BP may include a third light emitting element emitting a third light. Here, the first light may be light in a red wavelength band, the second light may be light in a green wavelength band, and the third light may be light in a blue wavelength band. The red wavelength band may be a wavelength band of approximately 600 nanometers (nm) to 750 nm, the green wavelength band may be a wavelength band of approximately 480 nm to 560 nm, and the blue wavelength band may be a wavelength band of approximately 370 nm to 460 nm, but embodiments of the present disclosure are not limited thereto.

Each of the first sub-pixel RP, the second sub-pixel GP, and the third sub-pixel BP may include an inorganic light emitting element having an inorganic semiconductor as the light emitting element that emits light. For example, the inorganic light emitting element may be a flip-chip type micro Light Emitting Diode (LED), but embodiments of the present disclosure are not limited thereto.

As shown in FIGS. 2 and 3, the area of the first sub-pixel RP, the area of the second sub-pixel GP, and the area of the third sub-pixel BP may be substantially the same, but embodiments of the present disclosure are not limited thereto. At least one of the area of the first sub-pixel RP, the area of the second sub-pixel GP, or the area of the third sub-pixel BP may be different from the others in another embodiment. Alternatively, any two of the area of the first sub-pixel RP, the area of the second sub-pixel GP, and the area of the third sub-pixel BP may be substantially the same, and the other may be different from the above two. Alternatively, the area of the first sub-pixel RP, the area of the second sub-pixel GP, and the area of the third sub-pixel BP may be different from each other.

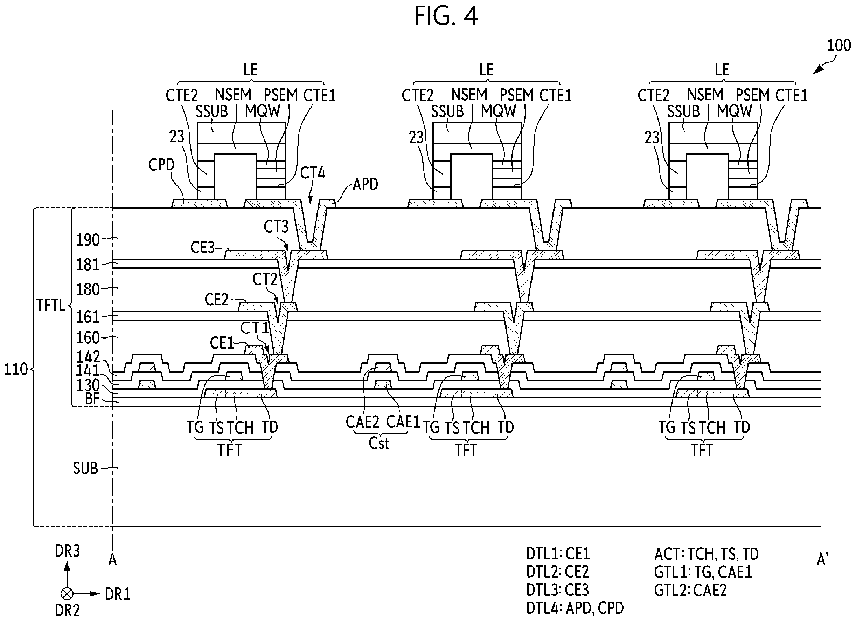

FIG. 4 is a cross-sectional view illustrating an example of a display panel cut along line A-A' of FIG. 2.

Referring to FIG. 4, the display panel 100 may include a thin film transistor layer TFTL and light emitting elements LE disposed on a substrate SUB. The thin film transistor layer TFTL may be a layer in which thin film transistors TFT are formed.

The thin film transistor layer TFTL includes an active layer ACT, a first gate layer GTL1, a second gate layer GTL2, a first data metal layer DTL1, a second data metal layer DTL2, a third data metal layer DTL3, and a fourth data metal layer DTL4. In addition, the thin film transistor layer TFTL includes a buffer film BF, a gate insulating film 130, a first interlayer insulating film 141, a second interlayer insulating film 142, a first planarization film 160, a first insulating film 161, a second planarization film 180, and a second insulating film 181.

The substrate SUB may be a base member for supporting the display device. The substrate SUB may be a rigid substrate made of glass, but the embodiments of the present disclosure are not limited thereto. The substrate SUB may be a flexible substrate capable of bending, folding, rolling, etc. in another embodiment. In this case, the substrate SUB may include an insulating material such as a polymer resin such as polyimide (PI).

The buffer film BF may be disposed on one surface of the substrate SUB. The buffer film BF may be a film to prevent penetration of air or moisture. The buffer film BF may be composed of a plurality of inorganic films stacked alternately. For example, the buffer film BF may be formed as a multilayer of alternately stacked inorganic films of one or more of a silicon nitride layer, a silicon oxynitride layer, a silicon oxide layer, a titanium oxide layer, and an aluminium oxide layer. The buffer film BF may be omitted.

The active layer ACT may be disposed on the buffer film BF. The active layer ACT may include a silicon semiconductor, such as polycrystalline silicon, monocrystalline silicon, low temperature polycrystalline silicon, and amorphous silicon, or may include an oxide semiconductor.

The active layer ACT may include a channel TCH, a first electrode TS, and a second electrode TD of a thin film transistor TFT. The channel TCH of the thin film transistor TFT may be a region that overlaps a gate electrode TG of the thin film transistor TFT in the third direction DR3, which is the thickness direction of the substrate SUB. The first electrode TS of the thin film transistor TFT may be disposed on one side of the channel TCH, and the second electrode TD may be disposed on the other side of the channel TCH. The first electrode TS and the second electrode TD of the thin film transistor TFT may be regions that do not overlap the gate electrode TG in the third direction DR3. The first electrode TS and the second electrode TD of the thin film transistor TFT may be conductive regions in which silicon semiconductors or oxide semiconductors are doped with ions.

The gate insulating film 130 may be disposed on the active layer ACT. The gate insulating film 130 may be formed of an inorganic film, such as a silicon nitride layer, a silicon oxynitride layer, a silicon oxide layer, a titanium oxide layer, or an aluminium oxide layer.

The first gate layer GTL1 may be disposed on the gate insulating film 130. The first gate layer GTL1 may include the gate electrode TG of the thin film transistor TFT and a first capacitor electrode CAE1. The first gate layer GTL1 may be formed as a single layer or multiple layers of any one of molybdenum (Mo), aluminium (Al), chromium (Cr), gold (Au), titanium (Ti), nickel (Ni), neodymium (Nd), and copper (Cu), or an alloy thereof.

The first interlayer insulating film 141 may be disposed on the first gate layer GTL1. The first interlayer insulating film 141 may be formed of an inorganic film, such as a silicon nitride layer, a silicon oxynitride layer, a silicon oxide layer, a titanium oxide layer, or an aluminium oxide layer.

The second gate layer GTL2 may be disposed on the first interlayer insulating film 141. The second gate layer GTL2 may include a second capacitor electrode CAE2. The second gate layer GTL2 may be formed as a single layer or multiple layers of any one of molybdenum (Mo), aluminium (Al), chromium (Cr), gold (Au), titanium (Ti), nickel (Ni), neodymium (Nd), and copper (Cu), or an alloy thereof.

The second interlayer insulating film 142 may be disposed on the second gate layer GTL2. The second interlayer insulating film 142 may be formed of an inorganic film, such as a silicon nitride layer, a silicon oxynitride layer, a silicon oxide layer, a titanium oxide layer, or an aluminium oxide layer.

The first data metal layer DTL1 including a first connection electrode CE1, a first sub-pad (not shown), and a data line (not shown) may be disposed on the second interlayer insulating film 142. The data line may be formed integrally with the first sub-pad, but the embodiments of the present disclosure are not limited thereto. The first data metal layer DTL1 may be formed as a single layer or multiple layers of any one of molybdenum (Mo), aluminium (Al), chromium (Cr), gold (Au), titanium (Ti), nickel (Ni), neodymium (Nd), and copper (Cu), or an alloy thereof.

The first connection electrode CE1 may be connected to the first electrode TS or the second electrode TD of the thin film transistor TFT through a first contact hole CT1 penetrating the first interlayer insulating film 141, the second interlayer insulating film 142, and the gate insulating film 130.

The first planarization film 160 may be disposed on the first data metal layer DTL1 to flatten the steps caused by the active layer ACT, the first gate layer GTL1, the second gate layer GTL2, and the first data metal layer DTL1. The first planarization film 160 may be formed of an organic film, such as an acrylic resin, epoxy resin, phenolic resin, polyamide resin, polyimide resin, or the like.

The second data metal layer DTL2 may be disposed on the first planarization film 160. The second data metal layer DTL2 may include a second connection electrode CE2 and a second sub pad (not shown). The second connection electrode CE2 may be connected to the first connection electrode CE1 through a second contact hole CT2 penetrating the first insulating film 161 and the first planarization film 160. The second data metal layer DTL2 may be formed as a single layer or multiple layers of any one of molybdenum (Mo), aluminium (Al), chromium (Cr), gold (Au), titanium (Ti), nickel (Ni), neodymium (Nd), and copper (Cu), or an alloy thereof.

The second planarization film 180 may be disposed on the second data metal layer DTL2. The second planarization film 180 may be formed of an organic film such as an acrylic resin, an epoxy resin, a phenolic resin, a polyamide resin, a polyimide resin, or the like.

The third data metal layer DTL3 may be disposed on the second planarization film 180. The third data metal layer DTL3 may include a third connection electrode CE3 and a third sub-pad (not shown). The third connection electrode CE3 may be connected to the second connection electrode CE2 through a third contact hole CT3 penetrating the second insulating film 181 and the second planarization film 180. The third data metal layer DTL3 may be formed as a single layer or multiple layers of any one of molybdenum (Mo), aluminium (Al), chromium (Cr), gold (Au), titanium (Ti), nickel (Ni), neodymium (Nd), and copper (Cu), or an alloy thereof.

A third planarization film 190 may be disposed on the third data metal layer DTL3. The third planarization film 190 may be formed from an organic film, such as an acrylic resin, an epoxy resin, a phenolic resin, a polyamide resin, a polyimide resin, or the like.

The fourth data metal layer DTL4 may be disposed on the third planarization film 190. The fourth data metal layer DTL4 may include an anode pad electrode APD, a cathode pad electrode CPD, and a fourth sub-pad (not shown). The anode pad electrode APD may be connected to the third connection electrode CE3 through a fourth contact hole CT4 penetrating the third planarization film 190. The cathode pad electrode CPD may be supplied with a first power supply voltage that may be a low potential voltage. The fourth data metal layer DTL4 may be formed as a single layer or multiple layers of any one of molybdenum (Mo), aluminium (Al), chromium (Cr), gold (Au), titanium (Ti), nickel (Ni), neodymium (Nd), and copper (Cu), or an alloy thereof.

The light emitting element LE is illustrated as a flip-chip type micro LED in which the first contact electrode CTE1 and the second contact electrode CTE2 are disposed opposite the anode pad electrode APD and the cathode pad electrode CPD but is not limited thereto. The light emitting element LE may be an inorganic light emitting element made of an inorganic material such as GaN in another embodiment. The light emitting element LE may have a length of several to hundreds of µm in the first direction DR1, a length in the second direction DR2, and a length in the third direction DR3, respectively. For example, the length of the light emitting element LE may have a length in the first direction DR1, a length in the second direction DR2, and a length in the third direction DR3 of approximately 100 µm or less.

The light emitting elements LE may be formed by growing on a semiconductor substrate such as a silicon wafer. Each of the light emitting elements LE may be transferred directly from the silicon wafer onto the anode pad electrode APD and cathode pad electrode CPD of the substrate SUB. In this case, the first contact electrode CTE1 and the anode pad electrode APD can be bonded to each other through a bonding process. Furthermore, the second contact electrode CTE2 and the cathode pad electrode CPD may be bonded to each other through a bonding process. The first contact electrode CTE1 and the anode pad electrode APD may be electrically connected to each other through a bonding electrode 23. Additionally, the second contact electrode CTE2 and the cathode pad electrode CPD may be electrically connected to each other through the bonding electrode 23.

In one example, the bonding electrode 23 may be disposed on one surface of the light emitting element LE. The bonding electrode 23 may be a bonded product of pressurized melt bonding using a laser. Here, pressurized melt bonding refers to a state in which the bonding electrode 23 is melted under heat to melt and melt-mix the light emitting element LE, the anode pad electrode APD, and the cathode pad electrode CPD, and is cooled and solidified when the laser supply is terminated. The conductivity of the light emitting element LE, the anode pad electrode APD, and cathode pad electrode CPD is maintained while being cooled and solidified from the melt-mixed state, so that the anode pad electrode APD, cathode pad electrode CPD, and the light emitting element LE may be electrically connected and physically connected respectively. Accordingly, the bonding electrode 23 may be disposed on the first contact electrode CTE1 and the second contact electrode CTE2 of the light emitting element LE.

The bonding electrode 23 may include, for example, Au, AuSn, PdIn, InSn, NiSn, Au-Au, AgIn, AgSn, Al, Ag, or carbon nanotubes (CNT). Each of these may be utilized alone or in combination with two or more.

Each of the light emitting elements LE may be a light emitting structure including a base substrate SSUB, an n-type semiconductor NSEM, an active layer MQW, a p-type semiconductor PSEM, a first contact electrode CTE1, and a second contact electrode CTE2.

The base substrate SSUB may be a sapphire substrate, but embodiments of the present disclosure are not limited thereto.

The n-type semiconductor NSEM may be disposed on one surface of the base substrate SSUB. For example, an n-type semiconductor NSEM may be disposed on the bottom surface of the base substrate SSUB. The n-type semiconductor NSEM may be made of GaN doped with n-type conductive dopants such as Si, Ge, Sn, and the like.

The active layer MQW may be disposed on a portion of one side of the n-type semiconductor NSEM. The active layer MQW may include a material with a single or multiple quantum well structure. When the active layer MQW includes a material with a multiple quantum well structure, it may have a structure in which a plurality of well layers and barrier layers are alternately stacked. At this time, the well layer may be formed of InGaN, and the barrier layer may be formed of GaN or AlGaN but are not limited thereto. Alternatively, the active layer MQW may be a structure in which a semiconductor material with a large band gap energy and a semiconductor material with a small band gap energy are alternately stacked on top of each other or may include three or five different semiconductor materials depending on the wavelength band of the light emitted.

In one embodiment of the present disclosure, a flip-chip type light emitting element is described as an example, but the present disclosure is not limited to this and a vertical light emitting element may also be used.

In addition, the transfer substrate referred to in the present disclosure may be a relay substrate in which a plurality of light emitting elements have been transferred from a growth substrate on which a plurality of light emitting elements have been grown, or a substrate in which a plurality of light emitting elements may be transferred to a target substrate. Hereinafter, in the present disclosure, the terms transfer substrate and relay substrate may be used interchangeably with the same meaning.

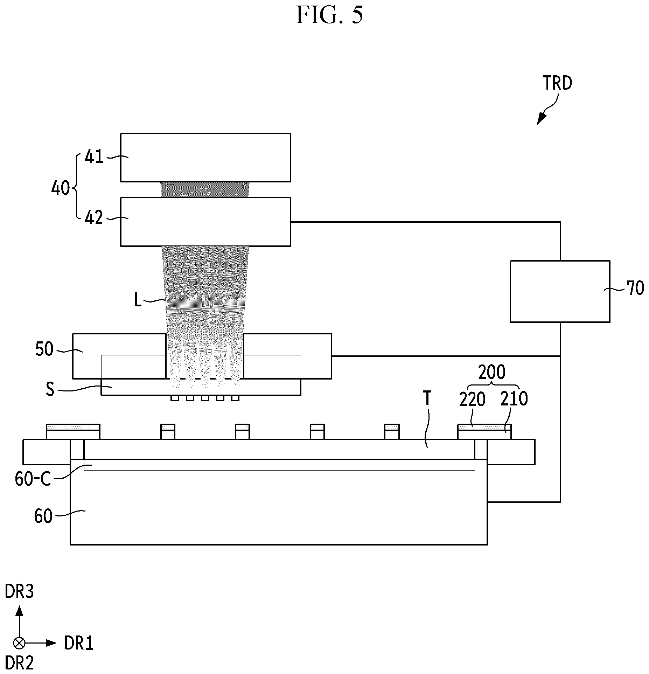

FIG. 5 is a schematic diagram illustrating a transfer device according to one embodiment.

The transfer device TRD according to one embodiment may be used to manufacture the display panel 100 (Referring to FIG. 4). For example, the transfer device TRD may be used in a transfer process to transfer the light emitting element LE to a circuit board (10 in FIG. 4).

The transfer device TRD may transfer a plurality of light emitting elements arranged on the transfer substrate S to the target substrate T.

Referring to FIG. 5, the transfer device TRD may include a light source portion 40, an upper stage 50, a lower stage 60, a mask 200, and a control portion 70.

The light source portion 40 may include a light source 41 and an optical system 42.

The light source 41 generates a laser beam. The light source 41 may be a laser oscillator, for example. For example, the laser oscillator may be a light source for irradiating the wavelength and energy required for a laser-induced forward transfer (LIFT) process to the processing surface, which is the interface between one surface (e.g., bottom surface) of the transfer substrate S and the light emitting element LE.

The laser oscillator provides driving force to transfer the light emitting element LE from the transfer substrate S to the target substrate T. If the laser beam pulse parameters are appropriately selected, the laser pulse separates the light emitting element LE from the transfer substrate S and causes it to be placed on the target substrate T.

The optical system 42 may be disposed on the optical path and guides the path of the laser beam generated from the light source 41 in a predefined spatial pattern, thereby simultaneously directing a plurality of output beams of the laser. For example, the optical system 42 may include one or more optical lenses, and the optical system 42 may be disposed between the light source 41 and the transfer substrate S.

In one embodiment, the optical system 42 may include a spatial light modulator (SLM) or a digital micromirror device (DMD). The optical system 42 may receive a single beam generated by the light source 41 and divide it into a plurality of laser beams to generate a multi-beam.

In one embodiment, the light source portion 40 is not shown, but a beam shaper may be positioned between the light source 41 and the optical system 42. The beam shaper may serve to change the collimated Gaussian input beam emitted from the light source 41 into a flat top beam with uniform intensity.

The upper stage 50 supports the transfer substrate S. For example, the upper stage 50 may include a clamp or the like. The upper stage 50 may hold the peripheral portion of the transfer substrate S. The upper stage 50 may support and move the transfer substrate S in the in-plane direction to align its position. Furthermore, the upper stage 50 may have a function of adjusting the height of the transfer substrate S in the vertical direction.

The transfer substrate S may have, for example, a light emitting element LE transferred to its surface and may be driven in two axes in a plane direction by the upper stage 50. The light emitting elements LE transferred to the transfer substrate S may be arranged by transferring micro LED chips on an epitaxial (EPI) wafer by a laser-induced forward transfer (LIFT) process, and a plurality of them may be arranged adjacent to each other and aligned up, down, left, and right. The transfer substrate S may be a rigid substrate or a flexible film.

The lower stage 60 may support the target substrate T.

The lower stage 60 may provide a seating surface on which the target substrate T is mounted, and the seating surface may be parallel to the first direction DR1 and the second direction DR2.

In one embodiment, the lower stage 60 may include a chuck 60-C that is one of an electrostatic chuck, an adhesive chuck, a vacuum chuck, or a porous vacuum chuck at one surface (e.g., top surface) of the lower stage 60. The lower stage 60 may fix the target substrate T through the chuck 60-C. The lower stage 60 may maintain and support the function of aligning the target substrate T by moving it in the in-plane direction. Additionally, the lower stage 60 may have a function of adjusting the height of the target substrate T in the vertical direction.

The target substrate T may be disposed opposite the transfer substrate S and may be driven in two axes in a plane direction by the lower stage 60. At this time, the target substrate T may be aligned with the transfer substrate S and then transferred together with the lower stage 60. Additionally, the target substrate T and the transfer substrate S may be driven independently by different stages 50 and 60 to implement relative movements. The target substrate T may be a rigid substrate, a flexible film, or a three-dimensional shape.

The mask 200 may be disposed on the target substrate T during the transfer process. In one embodiment, the base layer 210 of the mask 200 may be in contact with the target substrate T during the transfer process.

The mask 200 may mask some areas and not mask some areas on the target substrate T during the transfer process. In this way, some areas that are not masked may be transfer areas where the light emitting element LE may be transferred. That is, the mask 200 may have a pattern that defines the transfer area.

The mask 200 includes a base layer 210 and an adhesive layer 220 and may be in a film shape.

The base layer 210 may be made of polyethylene terephthalate (PET), polyurethane (PU), polyimide (PI), polycarbonate (PC), polyethylene (PE), polypropylene (PP), polysulfone (PSF), polymethylmethacrylate (PMMA), triacetyl cellulose (TAC), cycloolefin polymer (COP), or the like.

The adhesive layer 220 may be disposed on one surface (e.g., a top surface) of the base layer 210. The adhesive layer 220 may be made of an adhesive or adhesive material, and the adhesive material may include, for example, an optical clear adhesive ("OCA"), a pressure sensitive adhesive ("PSA"), and the like, and the adhesive may include, for example, an acrylic-based, urethane-based, or silicone-based adhesive material.

The adhesive layer 220 may have a pattern so that the arrangement of a plurality of light emitting elements LE defines the transfer area.

The adhesive layer 220 may define an opening 220-O therein formed in the transfer area. The size of the opening 220-O may be the same as the cell area corresponding to each display panel (100 in FIG. 1).

Since the mask 200 defines an opening 220-O corresponding to the cell area, which corresponds to the display panel, the light emitting elements may be arranged only in the cell area even if the laser beam simultaneously irradiates over an area larger than the display panels (e.g., the laser beam is a surface light source).

Further, in one embodiment, it is easy to form the shape and position of the opening in the mask 200, thereby enabling simultaneous transfer to a plurality of cell areas regardless of the cell shape.

In addition, in one embodiment, the mask 200 is not disposed on the upper or lower surface of the transfer substrate S, but on the target substrate T. In this case, since the mask 200 is not disposed on the optical path, damage to the light source portion 40 caused by light reflection or the like from the mask 200 may be minimized.

The control portion 70 may include memory and a processor. The memory may be implemented as at least one of a flash memory type, a ROM, a RAM, a hard disk type, a multimedia card micro type, or a card type of memory (e.g., SD or XD memory, etc.).

The memory is electrically connected to the processor so that signals and information can be transmitted to and from the processor. Accordingly, the memory may store characteristic information of a plurality of micro LEDs that have been input or irradiated and transmit the stored characteristic information to the processor.

The processor controls the overall operation of the transfer device TRD. That is, the processor is electrically connected to the light source portion 40, the upper stage 50, and the lower stage 60 to control each configuration.

For example, the processor may control the light source portion 40, the upper stage 50, and the lower stage 60 to transfer a plurality of micro LEDs arranged on the transfer substrate S to the target substrate T. The processor is not limited to controlling all components by a single processor but may control each component of the transfer device TRD using multiple independent processors.

Here, the processor may include one or more of a central processing unit (CPU), a controller, an application processor (AP), a communication processor (CP), or an ARM processor.

In addition, the processor may be electrically connected to a memory and may use characteristic information of multiple micro LEDs stored in the memory. The characteristic information of the multiple micro LEDs may be data to ensure uniformity in the overall arrangement when transferred to the target substrate T.

In one embodiment, the processor examines the characteristics of a plurality of micro LEDs formed on red, green, and blue growth substrates, and analyzes the luminance and wavelength of the micro LEDs for each area of each growth substrate. The results analyzed in this way may be stored in memory.

Based on the analysis results, when arranging multiple red, green, and blue micro LEDs from each growth substrate to a relay substrate or temporary substrate, simulate combinations of each position for optimal arrangement considering uniformity, etc.

Once the optimal arrangement of a number of red, green, and blue micro LEDs to be disposed on a temporary substrate or transfer substrate S is established through simulation, the processor may form a data map based on this. The data map may be stored in memory.

Then, based on the data map, the micro LEDs of each growth substrate may be transferred to the corresponding temporary substrate or transfer substrate S using the LIFT method.

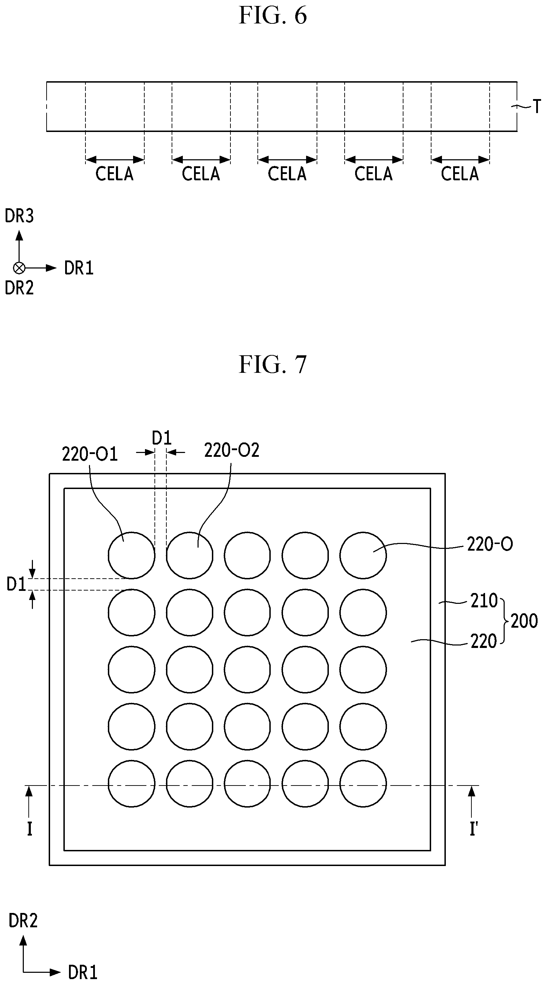

FIG. 6 is a cross-sectional view illustrating a schematic shape of a target substrate according to one embodiment.

Referring to FIG. 6, the target substrate T may be a backplane substrate (e.g., the backplane substrate 110 of each display panel 100 of FIG. 4) including a plurality of cell areas CELA. Each cell area CELA may include a plurality of light emitting areas, and one or more light emitting elements may be disposed in each light emitting area. Accordingly, a plurality of light emitting element arrays may be disposed in each cell area.

The target substrate T may be a backplane substrate 110 used to simultaneously manufacture a plurality of display panels 100.

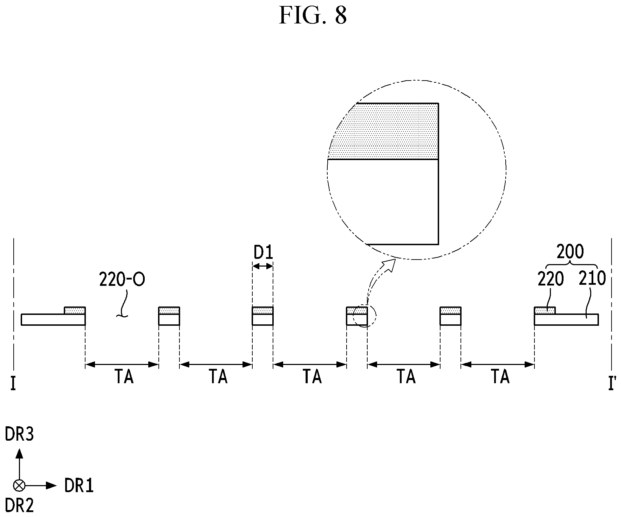

FIG. 7 is a plan view of a mask according to one embodiment. FIG. 8 is a cross-sectional view of a mask of one embodiment taken along line I-I' in FIG. 7. As used herein, the "plan view" is a view in a thickness direction (i.e., DR3) of the mask 200.

Referring to FIGS. 7 and 8, the mask 200 includes a base layer 210 and an adhesive layer 220 disposed on the base layer 210.

The base layer 210 may define a plurality of openings 220-O. Each opening 220-O may define a transfer area TA. Each opening 220-O may be disposed at a first distance D1 from a neighboring opening. The transfer area TA may correspond to the cell area CELA of the target substrate T. The first distance D1 may be wider than the width of the light emitting element LE but is not limited thereto.

In one embodiment, each opening 220-O may have a size corresponding to an area of the backplane substrate 110 (e.g., an area corresponding to an area of the backplane substrate) to allow plurality of light emitting elements to be disposed on the cell areas CELA of the target substrate T. Further, each opening 220-O may have a shape corresponding to the shape of the backplane substrate 110 or the shape of the cell area CELA in a plan view. For example, when the backplane substrate 110 or the cell area CELA is circular, each opening 220-O may be formed in a circular shape.

A shape of the adhesive layer 220 may follow the shape of the base layer 210. For example, if the base layer 210 is square in a plan view, the adhesive layer 220 may also be square, and if the base layer 210 is circular, the adhesive layer 220 may also be circular. The adhesive layer 220 may be smaller than or equal to the area of the base layer 210 in a plan view.

In one embodiment, the area of the adhesive layer 220 may be equal to or smaller than the area of the base layer 210. The adhesive layer 220 may define an opening that overlaps the opening 220-O in the base layer 210 in a plan view. The opening in the adhesive layer 220 may be the same as the opening 220-O in the base layer 210 in cross-section and plan views. Accordingly, the mask 200 may define an opening that penetrates the base layer 210 and the adhesive layer 220.

A side surface of the opening 220-O in the base layer 210 may have a rectangular shape in cross-section. The angle between the bottom surface of the base layer 210 and the side surface of the base layer 210 connected to the bottom surface may be substantially a right angle. Accordingly, the side surfaces of the opening 220-O in the base layer 210 adjacent in the first direction DR1 may be substantially perpendicular to the first direction DR1.

In this disclosure, "on a plane" is defined as viewed in a normal direction of the plane defined by the first direction DR1 and the second direction DR2 (i.e., in a plan view). In this disclosure, "in cross-section" is defined as viewed in the first direction DR1 or the second direction DR2.

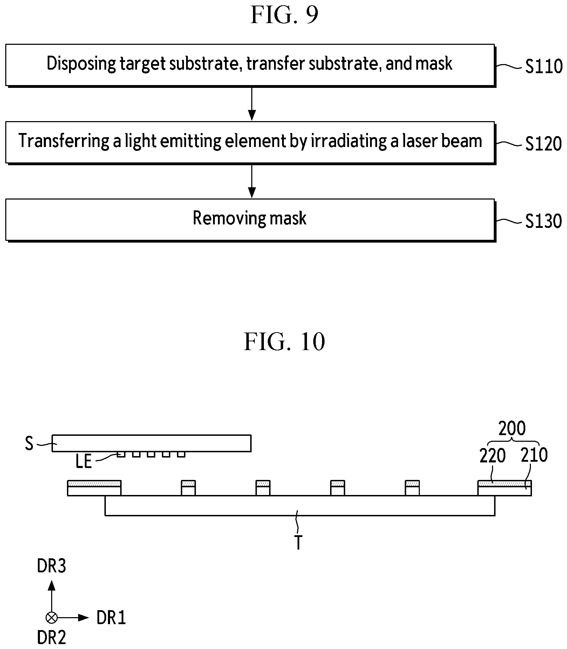

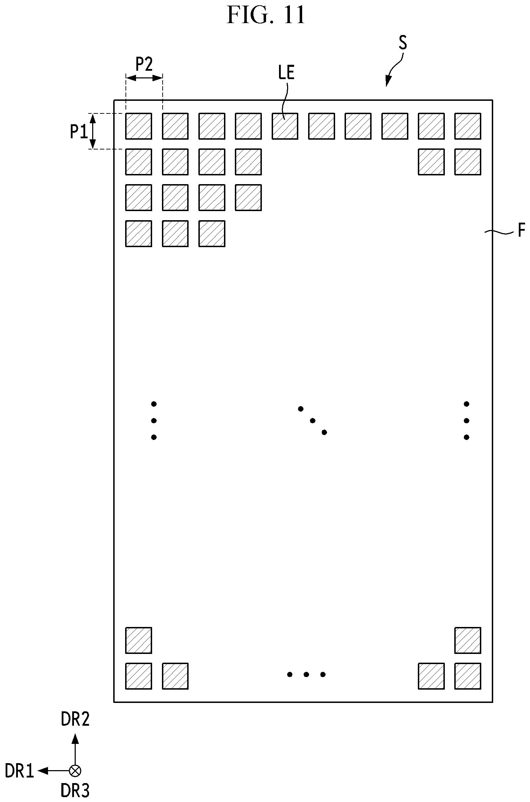

FIG. 9 is a flowchart illustrating a method of transferring a light emitting element according to one embodiment. FIGS. 10 to 15 are cross-sectional or plan views to illustrate a light emitting element transfer method. FIGS. 10, 12 to 15 illustrate cross-sectional views of a transfer substrate and a target substrate according to the transfer order of the light emitting element. FIG. 11 is a plan view illustrating one surface of a transfer substrate according to one embodiment.

FIGS. 10 to 15 mainly illustrate the mask 200, the light emitting element LE, the transfer substrate S, and the target substrate T, which may correspond to the cross-sectional views of the mask 200, the light emitting element LE, the transfer substrate S, and the target substrate T described with reference to FIGS. 5 to 8, respectively. In the following, a method of transferring the light emitting element illustrated in FIGS. 10 to 15 will be described in conjunction with FIG. 9.

Referring to FIG. 10, the target substrate T and the transfer substrate S are disposed to face each other, and the mask 200 is disposed on the target substrate T at a distance from the transfer substrate S. (S110 in FIG. 9)

Referring to FIG. 11, a plurality of light emitting elements LE may be arranged in a grid-like arrangement at regular interval P1 in a column direction (i.e., the second direction DR2) and regular interval P2 in a row direction (i.e., first direction DR1) on one surface F (e.g., bottom surface) of the transfer substrate S.

One surface F of the transfer substrate S may be disposed to face the target substrate T.

For example, the upper stage 50 of the transfer device TRD illustrated with reference to FIG. 5 may hold the peripheral portion of the transfer substrate S, and the lower stage 60 may fix the lower surface of the target substrate T by the chuck 60-C.

One surface (e.g., bottom surface) of the transfer substrate S on which the light emitting element LE is disposed may be disposed to face the target substrate T. Accordingly, the plurality of light emitting elements LE may be disposed to face the target substrate T.

As described with reference to FIGS. 7 and 8, the mask 200 may include a plurality of openings 220-O defining a transfer area TA on the front surface.

The mask 200 may be disposed on the target substrate T so that the adhesive layer 220 of the mask 200 faces the light emitting element LE. In one embodiment, the mask 200 is disposed to contact the target substrate T, but the present disclosure is not limited to this, and the mask 200 may be disposed at a certain distance from the target substrate T. Even when the mask 200 is disposed to be spaced apart from the target substrate T, the distance between the mask 200 and the target substrate T may be smaller than the height of the light emitting element LE.

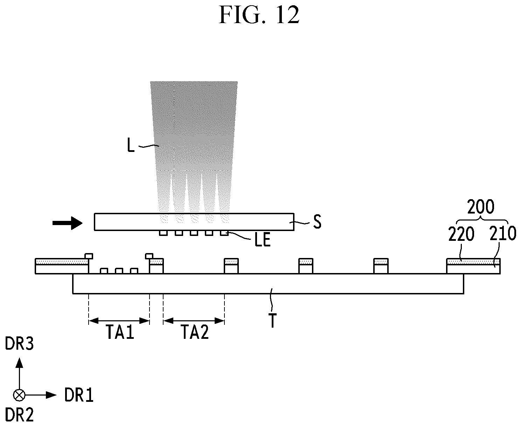

Referring to FIGS. 12 to 14, a plurality of light emitting elements LE are transferred by irradiating a laser beam L (S120 in FIG. 9).

In one embodiment, as shown in FIG. 12, the laser beam L is irradiated to the plurality of light emitting elements LE arranged on a bottom surface of the transfer substrate S and the bottom surface of the transfer substrate S. Accordingly, the plurality of light emitting elements LE are transferred to the first transfer area TA1 through the first opening (220-01 in FIG. 7) of the mask 200.

The light emitting element LE that does not pass through the first opening 220-O1 in the mask 200 may be disposed on the adhesive layer 220 on the upper surface of the mask 200.

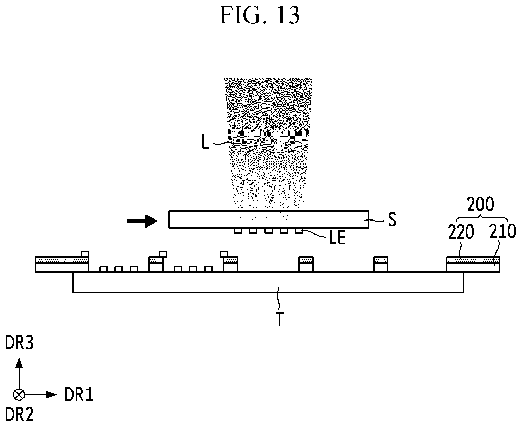

Then, as shown in FIG. 13, the transfer substrate S is moved to transfer the plurality of light emitting elements LE to the second transfer area TA2 through the second opening (220-O2 in the mask 200 in FIG. 7).

For example, the transfer substrate S is moved to the upper stage 50 in the first direction DR1 or the second direction DR2, and the light emitting element LE is transferred to the next transfer area.

In one embodiment, the transfer substrate S may have a smaller area than the target substrate T. After all of the light emitting elements LE arranged on the transfer substrate S are transferred to the target substrate T, if there are additional transfer areas TA on the target substrate T where the light emitting elements LE have not been transferred, the transfer substrate S that has been transferred to the upper stage 50 may be replaced with a new transfer substrate S to continue transferring.

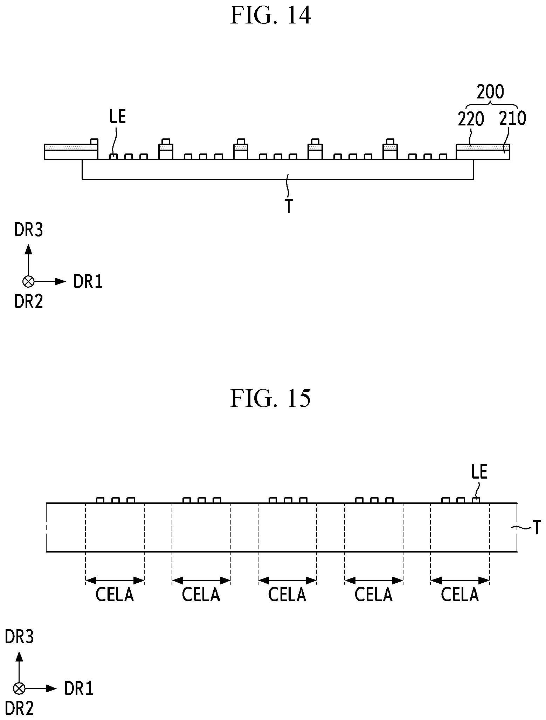

As shown in FIG. 14, the transfer substrate S is moved to transfer the light emitting element LE to the entire surface of the target substrate T.

Referring to FIG. 15, the mask 200 may be removed (S130 in FIG. 9).

As shown in FIG. 15, the mask 200 is removed leaving the light emitting element LE transferred on the target substrate T through the opening of the mask 200. By removing the mask 200, the light emitting element LE transferred to an area other than the transfer area defined by the opening 220-O in the mask 200 may be removed. That is, only the light emitting elements disposed in the cell area of the target substrate T remain.

The light emitting element LE disposed on the adhesive layer 220 on the top surface of the mask 200 may also be removed.

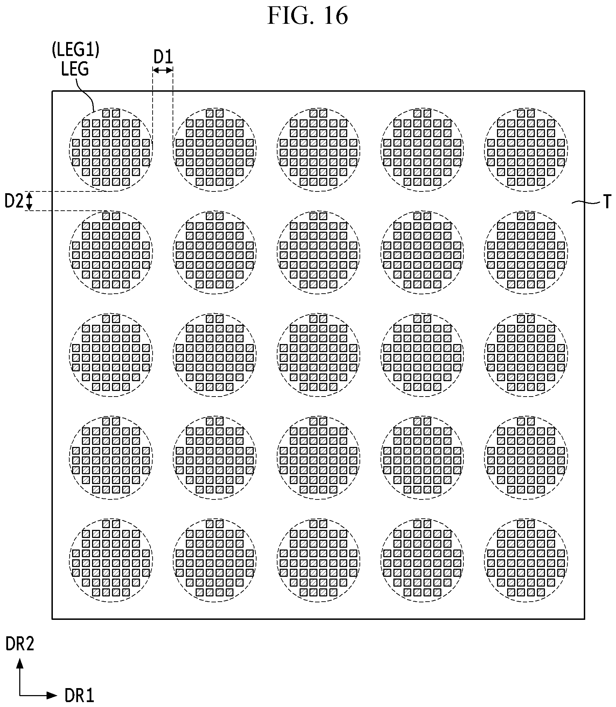

FIG. 16 is a plan view illustrating one surface of a target substrate on which a light emitting element is transferred according to one embodiment.

Referring to FIG. 16, the plurality of light emitting elements LE transferred to the target substrate T form a plurality of clusters LEG, and the arrangement shape of the clusters LEG follows the arrangement shape of the plurality of openings of the mask 200 in a plan view.

For example, as shown in FIGS. 7 and 11, suppose a mask 200 is used in which a plurality of openings 220-O are arranged in a grid-like arrangement at regular intervals P1 in a column direction (i.e., the second direction DR2) and regular intervals P2 in a row direction (i.e., first direction DR1) with each opening 220-O being circular. In this case, as shown in FIG. 16, a plurality of light emitting elements are arranged in a cluster LEG to follow the shape of the opening, and the cluster arrangement is formed to follow the shape of the arrangement of the openings. For example, the shape of the first group LEG1 forms a circle by following the shape of the opening 220-01 in the first row and first column of the mask 200 in a plan view. The plurality of clusters LEG forms a grid-like arrangement at regular intervals on the row direction and the column direction.

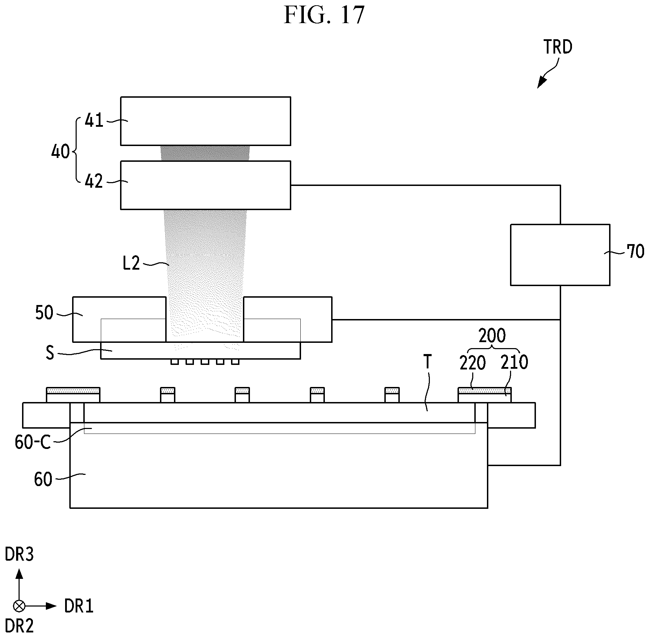

FIG. 17 is a schematic diagram illustrating a transfer device according to another embodiment.

FIG. 17 is different from the transfer device TRD of FIG. 5 in that the light emitting element is transferred using a laser lift-off (LLO) method. In the embodiment described with reference to FIG. 17, the description described above with reference to FIG. 5 may be applied in the same manner, except that the light source portion 40 irradiates the laser light L2 in the LLO method.

Unlike the LIFT method, the optical system 42 may irradiate a laser to the entire predefined area. For example, the entire cell area may be irradiated with the laser.

In this way, even when irradiating an entire area at once rather than multiple beams using the LLO method, a plurality of light emitting elements may be transferred simultaneously to the transfer area.

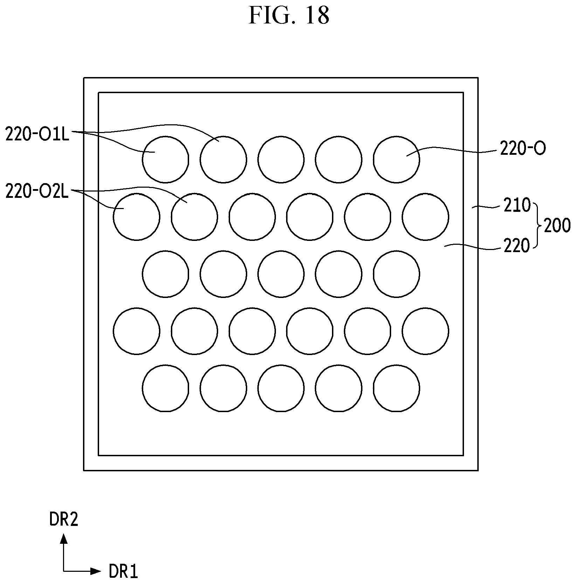

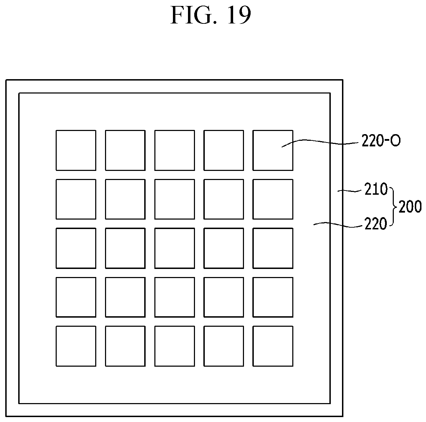

FIGS. 18 and 19 are plan views of a mask according to another embodiment. FIGS. 18 and 19 are different from the mask 200 described with reference to FIGS. 7 and 8 in the shape or arrangement of the opening 220-O of the mask 200. The embodiment described with reference to FIG. 18 may be described as described above with reference to FIGS. 7 and 8 except that the arrangement of the openings 220-O is such that the openings 220-O1L arranged in the first row and the openings 220-O2L arranged in the second row are not disposed in the same column.

Referring to FIG. 18, the arrangement of the openings 220-O is such that the respective centers of the openings 220-O1L of the first row and the respective centers of the openings 220-O2L of the second row do not coincide with each other in the second direction DR2. The center of each of the openings 220-O2L in the second row may be disposed between the openings 220-O1L in the first row in a view of the second direction DR2. In this way, when the center of the openings 220-O1L in the first row and the center of the openings 220-O2L in the second row are arranged to be offset, there is an advantage that more cells may be formed on the target substrate T compared to the other case.

Referring to FIG. 19, the opening 220-O may have a square shape on a plane (i.e., in a plan view). As shown in FIG. 19, depending on the shape of the cell, the shape of the opening 220-O may be changed to various shapes such as not only circular and rectangular, but also elliptical and hexagonal, and so on.

According to one embodiment, regardless of the shape of the cell, a plurality of light emitting elements may be formed simultaneously throughout the entire cell.

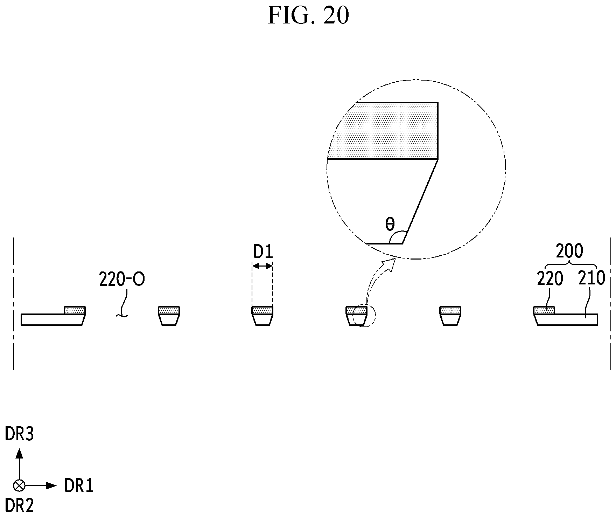

FIGS. 20 to 22 are cross-sectional views illustrating masks according to another embodiment.

FIGS. 20 to 22 are different from those in FIG. 8 in the cross-sectional shape of the opening 220-O of the mask 200. The embodiment described with reference to FIGS. 20 to 22 may be equally well described with reference to FIGS. 7 and 8, except that the cross-sectional shape of the opening 220-O is different.

Referring to FIGS. 20 to 22, the base layer 210 is different from the base layer 210 of FIGS. 7 and 8 in that the width of the opening increases from the top to the bottom of the base layer 210. As used herein, the "width" of the opening is measured in a direction parallel to a plane defined by the first and second directions DR1 and DR2.

Referring to FIG. 20, the side of the opening 220-O of the base layer 210 may have an inverted trapezoidal shape in cross-section. The width of the opening 220-O of the base layer 210 may become smaller along the third direction DR3. Accordingly, the width of the bottom surface of the base layer 210 in the first direction DR1 may be smaller than the width of the top surface of the base layer 210 in the first direction DR1. The angle θ between the bottom surface of the base layer 210 and the side surface of the base layer 210 connected to the bottom surface may be an obtuse angle exceeding 90 degrees.

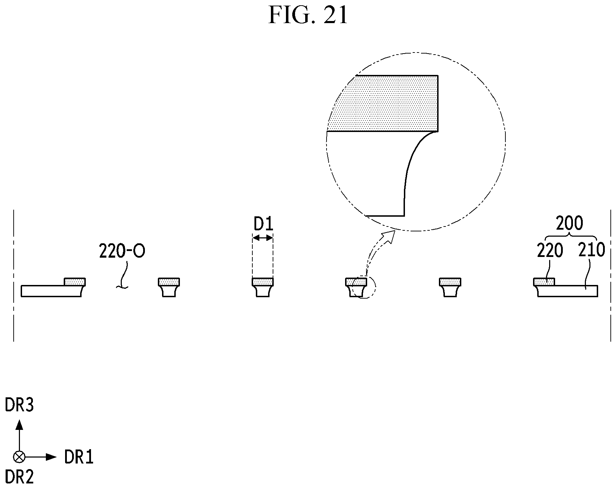

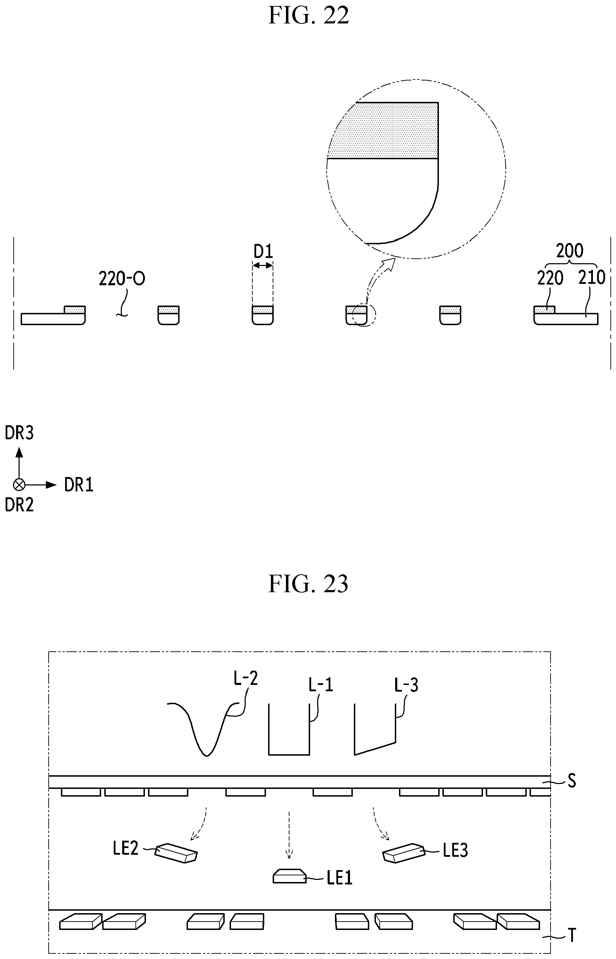

Referring to FIGS. 21 and 22, the side surface of the opening 220-O of the base layer 210 becomes smaller as it moves away along the third direction DR3 but may have a curvature. As shown in FIG. 21, the side curvature of the base layer 210 opening 220-O may be formed to increase toward the top, and as shown in FIG. 22, the side curvature of the opening 220-O in the base layer 210 may be formed to decrease toward the top.

FIG. 23 is a diagram to illustrate the effect of inclined sides of an opening according to one embodiment.

Referring to FIG. 23, it is possible to check the form of detachment of the light emitting element according to the shape of the laser beam in the LIFT method.

In the case of the flat top-shaped laser beam L-1 in which the laser beam is irradiated evenly on the irradiation surface, the laser beam L-1 is irradiated perpendicularly to the light emitting element LE1 and may be transferred to the desired location on the target substrate T. On the other hand, in the case where the laser beam is a Gaussian-shaped laser beam L-2 or a tilted-shaped laser beam L-3, the light emitting element LE2 or LE3 may not fall vertically and may not be transferred to the desired location on the target substrate T. As shown in FIGS. 20 to 22, when the width of the opening is formed to become wider from the top to the bottom of the base layer 210, the light emitting elements LE1 to LE3 may be disposed on the target substrate T along the side of the inclined opening even when the Gaussian-shaped laser beam L-2 or a tilted-shaped laser beam L-3 is irradiated to the light emitting elements LE1 to LE3.

However, the aspects of the disclosure are not restricted to the one set forth herein. The above and other aspects of the disclosure will become more apparent to one of ordinary skill in the art to which the disclosure pertains by referencing the claims, with functional equivalents thereof to be included therein.

## Claims

1. A mask comprising:
a base layer configured to be disposed on a target substrate and defining a plurality of openings therein arranged in a first direction and a second direction crossing the first direction; and
an adhesive layer disposed on the base layer and configured to face a transfer substrate,
wherein the plurality of openings defines a transfer area of the target substrate.

2. The mask of claim 1, wherein the transfer area corresponds to a cell area of the target substrate,
wherein each of the openings has a shape corresponding to a shape of the cell area, and each of the openings has an area corresponding to an area of the cell area in a plan view.

3. The mask of claim 1 or claim 2, wherein each of the openings of the mask has an upper width equal to or wider than a lower width.

4. A transfer device comprising:
a light source portion configured to irradiate a laser beam;
an upper stage disposed on a path of the laser beam and configured to support a transfer substrate;
a lower stage configured to support a target substrate facing the transfer substrate; and
a mask configured to be disposed on the target substrate and face the transfer substrate,
wherein the mask includes a base layer defining a plurality of openings therein arranged in a first direction and a second direction crossing the first direction and defining a transfer area of the target substrate and an adhesive layer disposed on the base layer and configured to face the transfer substrate.

5. The transfer device of claim 4, wherein the transfer area corresponds to a cell area of the target substrate,
wherein each of the openings has a shape corresponding to a shape of the cell area, and each of the openings has an area corresponding to an area of the cell area in a plan view.

6. The transfer device of claim 4 or claim 5, wherein a width of an upper portion of each of the openings is equal to or wider than a width of a lower portion thereof.

7. The transfer device of claim 5 or claim 6, wherein each of the openings has a side surface with a curvature.

8. The transfer device of any one of claims 4 to 7, wherein:
(i) the lower stage includes a chuck disposed at a top surface of the lower stage and capable of adsorbing to a rear surface of the target substrate; and/or
(ii) the mask is disposed to be spaced apart from the transfer substrate.

9. The transfer device of any one of claims 4 to 8, wherein:
(i) the adhesive layer is disposed to face a light emitting element disposed on the transfer substrate; and/or
(ii) the mask is disposed in contact with the target substrate.

10. The transfer device of any one of claims 4 to 9, wherein:
(i) the light source portion comprises:
a light source configured to generate the laser beam; and
an optical system disposed on a path of the laser beam and configured to guide the laser beam; and/or
(ii) the light source portion is configured to irradiate the laser beam using a laser-induced forward transfer (LIFT) method or a laser lift-off (LLO) method.

11. The transfer device of any one of claims 4 to 10, wherein the mask has a film shape,
wherein the base layer includes at least one of polyethylene terephthalate (PET), polyurethane (PU), polyimide (PI), polycarbonate (PC), polyethylene (PE), polypropylene (PP), polysulfone (PSF), polymethylmethacrylate (PMMA), triacetyl cellulose (TAC), or cycloolefin polymer (COP),
wherein the adhesive layer includes at least one of acrylic-based, urethane-based, or silicone-based adhesive materials.

12. A transfer method of a plurality of light emitting elements comprising:
disposing a transfer substrate and a target substrate to face each other, and disposing a mask on the target substrate to face the transfer substrate;
irradiating a light source to an interface between the transfer substrate and the plurality of light emitting elements disposed on the transfer substrate to transfer the plurality of light emitting elements onto the target substrate; and
removing the mask to remove at least one light emitting element, among the plurality of light emitting elements, transferred to an area other than a transfer area defined by an opening in the mask.

13. The method of claim 12, wherein the transfer area corresponds to a cell area of the target substrate,
wherein the opening has a shape corresponding to a shape of the cell area, and the opening has an area corresponding to an area of the cell area in a plan view.

14. The method of claim 13, wherein the mask includes an adhesive layer disposed at an upper portion of the mask, and the adhesive layer is disposed to face certain light emitting elements among the plurality of light emitting elements disposed on the transfer substrate,
wherein, in the transferring of the plurality of light emitting elements onto the target substrate,
some of the plurality of light emitting elements disposed on the transfer substrate are transferred to the cell area through the opening, and
the remainder of the plurality of light emitting elements are transferred to the adhesive layer of the mask, optionally wherein the plurality of light emitting elements transferred to the target substrate forms a plurality of groups, and a shape and area of each group follow a shape and area of the opening.

15. The method of any one of claims 12 to 14, wherein, in the disposing of the transfer substrate and the target substrate to face each other and the disposing of the mask on the target substrate to face the transfer substrate,
an upper stage grips a peripheral portion of the transfer substrate, and
a lower stage supports one surface of the target substrate, optionally wherein the lower stage adsorbs and supports the one surface of the target substrate using a chuck disposed at a top surface of the lower stage.
